Europäisches Patentamt

European Patent Office

Office européen des brevets

(11) Numéro de publication: **0 266 267**
**A1**

## (12) DEMANDE DE BREVET EUROPEEN

(21) Numéro de dépôt: 87402388.0

(22) Date de dépôt: 23.10.87

(51) Int. Cl.$^4$: **G 06 F 12/06**
**G 11 C 8/00**

(30) Priorité: 28.10.86 FR 8614976

(43) Date de publication de la demande:
04.05.88 Bulletin 88/18

(84) Etats contractants désignés:
CH DE ES FR GB IT LI NL

(71) Demandeur: **THOMSON SEMICONDUCTEURS**
**101, bld Murat**
**F-75016 - Paris (FR)**

(72) Inventeur: **Fruhauf, Serge**
**THOMSON-CSF SCPI 19, avenue de Messine**
**F-75008 Paris (FR)**

**Sourgen, Laurent**
**THOMSON-CSF SCPI 19, avenue de Messine**
**F-75008 Paris (FR)**

(74) Mandataire: **Ruellan-Lemonnier, Brigitte et al**
**THOMSON-CSF SCPI 19, avenue de Messine**
**F-75008 Paris (FR)**

(54) **Procédé d'adressage d'une mémoire et compteur d'adresse pour la mise en oeuvre du procédé.**

(57) La présente invention concerne un procédé d'adressage d'une mémoire divisée en zones, elles-mêmes divisées en blocs, chaque bloc étant composé de $2^n$ mots. Elle concerne aussi un compteur d'adresse binaire pour la mise en oeuvre du procédé.

Ce compteur d'adresse binaire du type comportant m étages (A0, A1, ... A6, ...) avec $2^m$ correspondant au nombre total de mots de la mémoire, chaque étage présentant une sortie et une entrée remise à zéro réalise un comptage pas à pas et comporte de plus des moyens (10) pour réaliser une incrémentation de $2^n$ ($n \leqq m$) et des moyens (11) de remise à zéro des n bits de poids faible de l'adresse.

Application aux mémoires ROM, RAM, EPROM, EEPROM ou similaire.

FIG_4

## Description

PROCEDE D'ADRESSAGE D'UNE MEMOIRE ET COMPTEUR D'ADRESSE POUR LA MISE EN OEUVRE DU PROCEDE.

La présente invention concerne un procédé d'adressage d'une mémoire. Elle concerne aussi un compteur d'adresse perfectionné pour la mise en oeuvre du procédé.

Les mémoires sont des composants électroniques permettant d'enregistrer et de stocker sous forme binaire divers types d'informations. Pour faciliter la gestion d'une mémoire, cette dernière est en général découpée en zones de longuer aléatoire. Les conditions d'accès à ces zones peuvent être différentes, soit à cause de la technologie dans laquelle est réalisée la mémoire, soit à cause de restrictions imposées par l'application qui peut réserver l'accès à certaines zones à des utilisateurs privilégiés ou similaires.

D'autre part, dans certaines applications où la sécurité est très importante telles que les applications "cartes à mémoire", les zones sont elles-mêmes découpées en blocs comportant un nombre fixe de mots, chaque mot étant constitué par un certain nombre de positions binaires ou bits. Les blocs peuvent éventuellement être découpés en sous-blocs, sous-sous-blocs et ainsi de suite, tous ces éléments comportant un nombre fixe de mots. Dans ce cas, le ou les premiers mots des blocs, sous-blocs ou sous-sous-blocs ont une fonction particulière d'autorisation d'accès au reste du bloc, sous-bloc, sous-sous-bloc ...

En général, l'accès aux différents mots d'une mémoire est réalisé à l'aide d'un compteur d'adresse utilisant plusieurs types de commande. Dans le case notamment des mémoires à logique de commande câblée, le compteur d'adresse comporte une commande d'incrémentation unitaire permettant un balayage séquentiel d'un mot au mot suivant et une remise à zéro permettant un retour à l'adresse zéro. Or, lorsque la mémoire est découpée en blocs dont le ou les premiers mots ont une fonction particulière d'autorisation d'accès au rest du block, ce système d'adressage est particulièrement long. En effet, il est en général nécessaire de revenir en début de bloc pour écrire les conditions d'accès au bloc après avoir écrit certains mots dans le bloc. Ceci ne peut être réalisé qu'en remettant l'adresse à zéro et en incrémentant l'adresse de manière unitaire jusqu'à obtenir l'adresse du ou des premiers mots du bloc. Ceci est identique pour l'accès aux sous-blocs et aux sous-sous-blocs. En conséquence, il existe une demande pour un procédé d'adressage permettant d'accéder facilement au niveau du bloc et éventuellement au niveau des sous-blocs et sous-sous-blocs inclus les uns dans leas autres et dans les blocs.

Ainsi, la présente invention a pour objet un procédé d'adressage d'une mémoire divisée en au moins une zone, elle-même divisée en blocs et sous-blocs inclus les dans les autres, chaque bloc étant composé de $2^n$ mots (avec $n \geqq 1$) et les sous-blocs étant composés de $2^{n1}$, $2^{n2}$, ... $2^{nm}$ mots, avec n1, n2, ... nm $\geqq 0$ et choisis tels que n > n1 > n2 > ... > nm, et chaque mot étant adressable par l'intermédiaire d'un compteur d'adresse binaire, caractérisé en ce que l'adressage est réalisé de manière sélective, soit par balayage séquentiel d'un mot au mot suivant, soit au niveau du bloc.

De manière préférentielle, l'adressage est réalisé de manière sélective, soit par incrémentation unitaire, soit par incrémentation de $2^n$ (avec $n \geqq 1$).

Selon une autre caractéristique de la présente invention lorsque les sous-blocs sont présents, l'incrémentation peut être réalisée au niveau des différents sous-blocs par des incrémentations de $2^{n1}$, $2^{n2}$, $2^{nm}$.

D'autre part, le procédé comporte une possibilité de retour en début de bloc. Ce retour en début de bloc est réalisé, de préférence, par remise à zéro des n bits de poids faible de l'adresse. Lorsque les sous-blocs sont présents, le procédé comporte aussi une possibilité de retour en début de sous-bloc réalisé de préférence par remise à zéro des n1, n2, ..., nm bits de poids faibles de l'adresse avec n1 > n2 > ... > nm.

La présente invention concerne aussi un compteur d'adresse binaire du type comportant m étages avec $2^m$ correspondant au nombre total de mots de la mémoire, chaque étage présentant une sortie et une entrée remise à zéro, ledit compteur réalisant un comptage pas à pas, caractérisé en ce qu'il comporte de plus des moyens pour réaliser une incrémentation de $2^n$ (n étant inférieur aou égal à m) et des moyens de remise à zéro des n bits de poids faible de l'adresse.

Selon une autre caractéristique, lorsque les sous-blocs sont présents, il comporte des moyens pour réaliser des incrémentations de $2^{n1}$, $2^{n2}$, ..., $2^{nm}$ avec n > n1 > n2 ... > nm et des moyens de remise à zéro des n1, n2, ..., nm bits de poids faible de l'adrese.

Selon un mode de réalisation préférentiel, les moyens pour réaliser une incrémentation de $2^n$ ou $2^{n1}$, $2^{n2}$,..., $2^{nm}$, sont constitués par une porte OU exclusif dont les entrées reçoivent respectivement la $n^{ième}$, $n1^{ième}$, ..., $nm^{ième}$ sortie du compteur et une impulsion de saut et dont la sortie est connectée en entrée de l'étage n+1, n1+1, ..., nm+1 du compteur.

D'autre part, selon un mode de réalisation préférentiel, les moyens de remise à zéro des n ou n1, n2, ..., nm bits de poids faible sont constitués par une porte OU recevant en entrée un signal de remise à zéro de bloc ou de sous-blocs et le signal de remise à zéro du compteur, la sortie de la porte OU étant connectée sur les entrées remises à zéro des n, n1, n2, ..., nm étages de poids faible du compteur.

D'autres caractéristiques et avantages de la présente invention apparaîtront à la lecture de la description d'un mode de réalisation faite ci-après avec référence aux dessins ci-annexés dans lesquels:

- la figure 1 est un schéma synoptique sucinct d'une mémoire à laquelle peut s'appliquer la présente invention,

- la figure 2 est un schéma représentant une bascule utilisée dans un compteur d'adresse binaire,

- la figure 3 représente schématiquement un compteur d'adresse binaire selon l'art antérieur, et

- la figure 4 représente un compteur d'adresse binaire selon un mode de réalisation de la présente invention.

Pour simplifier la description dans les figures les mêmes éléments portent des références identiques.

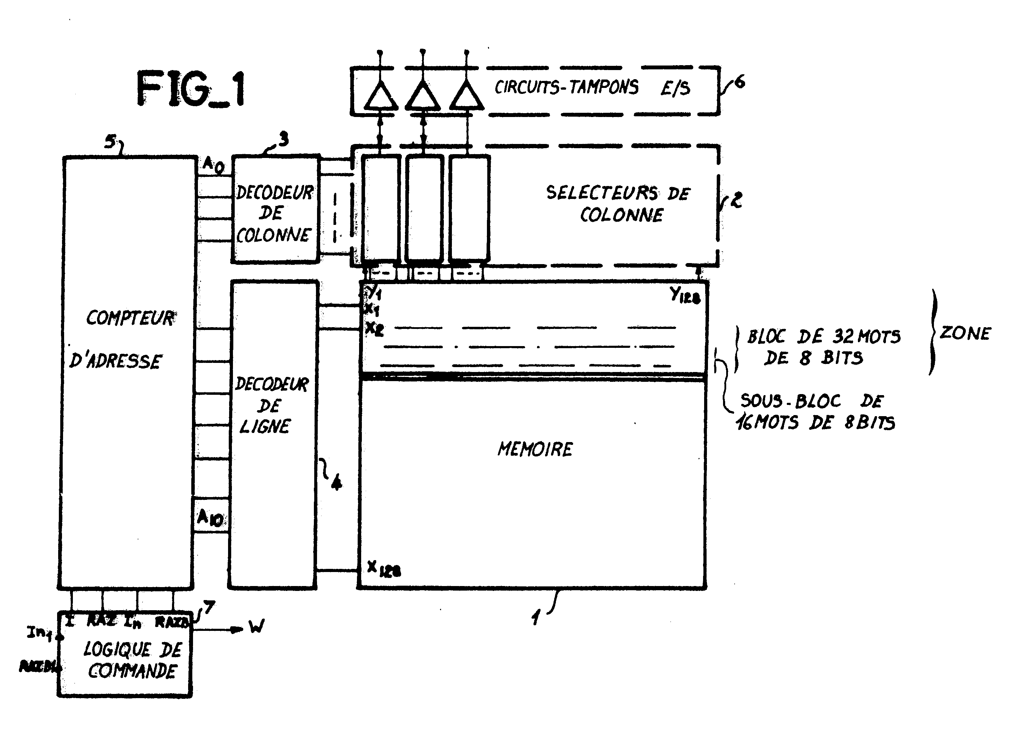

Sur la figure 1, on a représenté, sous forme d'un schéma synoptique, une mémoire ainsi que certains des circuits d'entrée/sortie et des circuits de connexion à la mémoire. Dans le cadre de la présente invention, la mémoire 1 peut être aussi bien une mémoire RAM qu'une mémoire ROM, une mémoire EPROM, une mémoire EEPROM ou similaire.

Dans le mode de réalisation représenté, on a choisi à titre d'exemple une mémoire comportant 16 324 cellules-mémoire agencées sous forme d'une matrice comportant 128 rangées ou lignes et 128 colonnes. On notera que le schéma synoptique de la figure 1 illustre une représentation fonctionnelle et non un agencement topologique réel du circuit intégré. D'autre part, les 128 colonnes Y1 à Y128 sont reliées à des sélecteurs de colonne 2. De manière plus spécifique, on a représenté sur la figure 1, 8 sélecteurs de colonne qui correspondent en fait chacun à un multiplexeur connecté à 16 lignes de colonne et permettant de sélectionner une des 16 lignes de colonne pour une programmation ou pour une connexion avec un des circuits tampons d'entrée/sortie 6. En effet, la mémoire représentée à titre d'exemple comporte des mots de 8 bits comme cela sera expliqué de manière plus détaillé ci-après. Les sélecteurs de colonne 2 sont connectés à un décodeur de colonne 3 qui présente 16 sorties et permet ainsi de sélectionner une des 16 colonnes reliées à chaque sélecteur de colonne. Par ailleurs, les 128 lignes X1 à X128 sont connectées à un décodeur de ligne 4.

Le décodeur de colonne 3 et le décodeur de ligne 4 sont tous deux connectés par l'intermédiaire de circuits tampon non représentés à un compteur d'adresse 5 qui présente 11 sorties A0 à A10. Le décodeur de colonne 3 est relié aux quatre sorties A0, A1, A2, A3 de poids faible du compteur d'adresse 5 tandis que le décodeur de ligne est relié aux autres sorties A4 à A10. Ce compteur d'adresse reçoit d'une logique de commande 7 un certain nombre de signaux de commande.

Dans les mémoires de l'art antérieur, les signaux de commande sont essentiellement le signal d'incrémentation unitaire I et un signal de remise à zéro du compteur référencé RAZ. Dans le mode de réalisation de la présente invention, le compteur d'adresse 5 reçoit en outre des signaux de saut In et In1 permettant un adressage au niveau du bloc et des sous-blocs et les signaux de remise à zéro de bloc RAZB et de sous-blocs RAZB1 permettant une remise à zéro au niveau d'un bloc et d'un sous-bloc.

La logique de commande émet en outre des signaux tels que le signal W permettant la lecture ou l'écriture dans la mémoire.

En fait, une mémoire telle que la mémoire 1 est destinée à enregistrer et stocker sous forme binaire un certain nombre d'informations. En général, certaines de ces informations ont un accès réservé et sont enregistrées dans des endroits spécifiques de la mémoire. Pour faciliter la gestion d'une mémoire, celle-ci est le plus souvent découpée en zones de dimensions aléatoires, une telle zone a été symbolisée par les deux traits continus dans la mémoire de la figure 1. D'autre part, pour une meilleure gestion des informations, une zone est le plus souvent divisée en blocs de dimensions fixes et éventuellement en sous-blocs inclus les uns dans les autres. Ainsi, dans le mode de réalisation de la figure 1, la zone représentée a été divisée en deux blocs de 32 mots de 8 bits et chaque bloc a été divisé en deux sous-blocs de 16 mots de 8 bits. Lorsque la mémoire est ainsi découpée, il est important pour obtenir un gain de temps appréciable lors de l'accès à un mot de pouvoir adresser la mémoire au niveau d'un bloc et éventuellement d'un sous-bloc. Pour cela, conformément à la présente invention, on a mis en oeuvre un procédé d'adressage qui permet au compteur de s'incrémenter soit par pas unitaire, c'est-à-dire d'un mot au mot suivant à partir de l'adresse "0", soit par pas de $2^n$, à savoir dans le mode de réalisation représenté, par pas de $2^5 = 32$ mots, ce qui permet de passer aisément d'un bloc à l'autre, soit par pas de $2^{n1}$, à savoir, dans le mode de réalisation représentée, par pas de $2^4 = 16$ mots. D'autre part, pour éviter une remise à zéro générale du compteur alors que l'adressage reste au niveau du bloc, on a aussi prévu un signal RAZB permettant une remise à zéro au niveau d'un bloc et un signal RAZB1 permettant une remise à zéro au niveau d'un sous-bloc. Pour ce faire, et comme expliqué de manière plus détaillée ci-après, le signal RAZB remet à zéro les n bits de poids faible du compteur d'adresse et le signal RAZB1 remet à zéro les n1 bits de poids faible du compteur d'adresse, n étant supérieur à n1.

Cette possibilité d'adressage au niveau du bloc et du sous-bloc permet un gain de temps très appréciable. En effet, l'incrémentation de $2^n$ qui permet de passer d'un bloc au bloc suivant en une seule commande au lieu de $2^n$ commandes, donne un gain de temps directement proportionnel à la longueur des blocs. En fait, plus les blocs seront longs, plus le gain de temps sera important. Par ailleurs, la possibilité de remise à zéro au niveau du bloc améliore aussi le gain de temps. En effet, lorsque l'on écrit dans un bloc, il est parfois nécessaire de revenir écrire le premier mot du bloc pour modifier les conditions d'accès du bloc ainsi écrit. Si la possibilité de remise à zéro au niveau du bloc n'existe pas, il faut écrire les mots choisis, puis revenir à l'adresse "0" et incrémenter le compteur jusqu'au début du bloc choisi pour écrire le premier mot. Avec la remise à zéro sélective, on écrit les mots du bloc choisi, puis on revient au début du bloc pour écrire le mot de contrôle d'accès. Le gain de temps est dans ce cas fonction de la position du bloc dans l'espace mémoire. Les gains sont en fait plus importants pour les blocs situés à des adresses élevées. Le même raisonnement peut être effectué pour les sous-blocs.

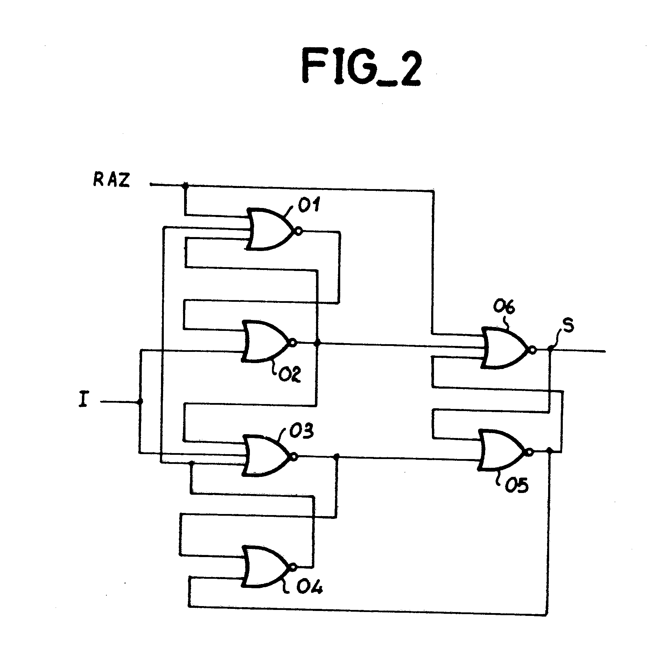

On décrira maintenant avec référence aux figure 2 à 4, un mode de réalisation d'un compteur d'adresse utilisable dans un système électronique à mémoire réalisé en logique câblée. Le compteur d'adresse habituellement utilisé est constitué à partir de bascules avec remise à zéro Une bascule de base a été représentée à titre d'exemple sur la figure 2. Cette bascule comporte une entrée incrémentation I et une entrée remise à zéro RAZ ainsi qu'une seule sortie S. Elle est constituée de six portes NI O1 à O6. Les six portes NI O1 à O6 sont connectées de la manière représentée sur la figure 2. Cette manière étant bien connue de l'homme de métier, elle ne sera pas redécrite ici. Avec la bascule de la figure 2, sur le front descendant du signal appliqué sur l'entrée I, la sortie S change d'état. Ainsi, la sortie S passe à "0" si elle était à "1" et vice-versa. D'autre part, une impulsion à "1" appliquée sur l'entrée RAZ force la sortie S à "0".

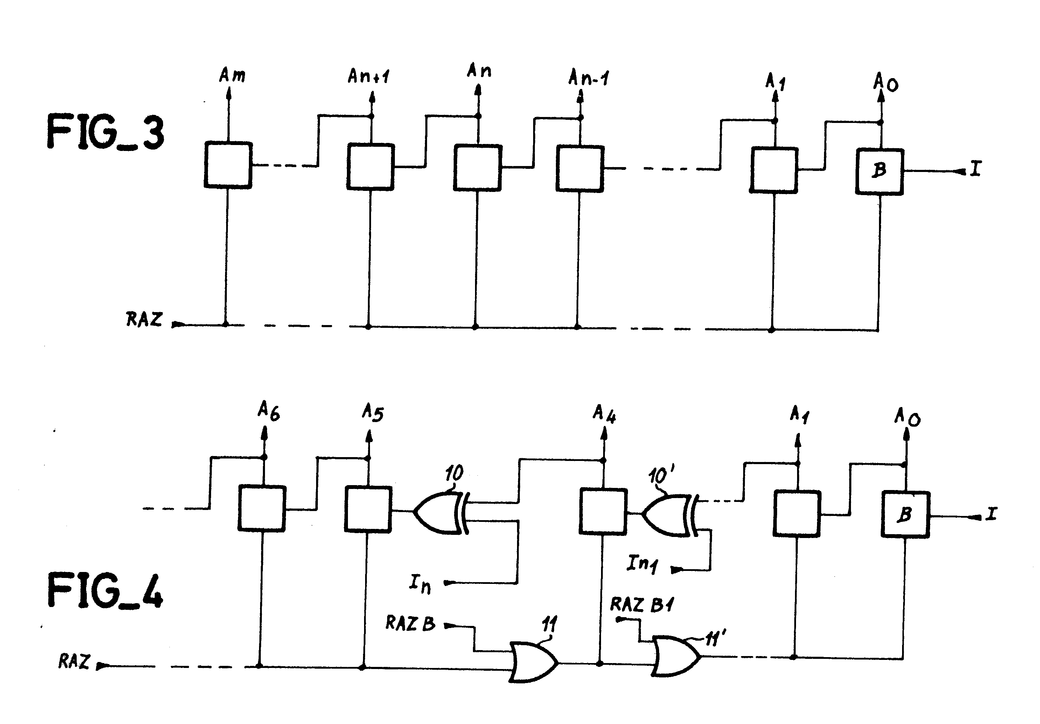

Comme représenté sur la figure 3, un compteur d'adresse est réalisé par l'assemblage de m bascules, à savoir onze bascules pour un mode de réalisation correspondant à la figure 1. La sortie de chaque bascule B est connectée à l'entrée I de la bascule correspondant à l'étage suivant. D'autre part, les onze sorties A0, A1, A2, A3, A4, A5, A6, A7, A8, A9, A10 des bacules seront envoyées sur les décodeurs de lignes et de colonnes. De plus, toutes les entrées sur les décodeurs de lignes et de colonnes. De plus, toutes les entrées RAZ des bascules B sont connectées en parallèle à un signal de remise à zéro. RAZ.

Pour la mise en oeuvre de la présente invention, le compteur de la figure 3 a été modifié comme représenté sur la figure 4 de telle sorte que le compteur puisse incrémenter par pas de $2^n$ ou par pas de $2^{n1}$, c'est-à-dire par pas de $2^5$ ou par pas de $2^4$ dans le mode de réalisation représenté, et puisse réaliser une remise à zéro au niveau du bloc ou du sous-bloc en remettant à zéro les n ou n1, à savoir cinq ou quatre bits de poids faible uniquement. Pour cela, on a prévu, entre la cinquième bascule et la sixième bascule, une porte OU exclusif 10 qui reçoit en entrée la sortie A4 de la cinquième bascule et un signal d'incrémentation In issu de la logique de commande. Ainsi, lorsqu'une impulsion est appliquée sur l'entrée In, on fait basculer la sortie A5 de la bascule, ce qui entraîne une incrémentation de l'adresse de $2^5$. De même, une porte OU exclusif 10' a été prévue entre la quatrième et la cinquième bascule. Cette porte 10' reçoit en entrée la sortie A3 de la quatrième bascule et le signal d'incrémentation In1 issue de la logique de commande. Si une impulsion In1 est appliquée sur la porte 10', la sortie A4 bascule, ce qui entraîne une incrémentation de l'adresse de $2^4$. D'autre part, pour obtenir une remise à zéro au niveau du bloc, on a prévu une porte OU 11 qui reçoit en entrée le signal RAZ et un signal RAZB issu de la logique de commande et dont la sortie est connectée sur les entrées remise à zéro des cinq bascules de poids faible donnant les sorties A4 à A0. De même, pour obtenir une remise à zéro au niveau du sous-bloc, on a prévu une porte OU 11' qui reçoit en entrée le signal RAZ et un signal RAZB1 issu de la logique de commande et dont la sortie est connectée sur les entrées remise à zéro des quatre bascules de poids faible.

Le compteur d'adresse décrit ci-dessus a été donné à titre d'exemple. Il est évident pour l'homme de l'art que d'autres types de compteurs d'adresse peuvent être utilisés pour la mise en oeuvre de la présente invention. Le compteur décrit présente l'avantage d'une très grande simplicité.

D'autre part, il est évident pour l'homme de l'art que les sous-blocs peuvent être divisés et/ou une incrémentation et une remise à zéro peuvent être prévues à ce niveau.

## Revendications

1. Un procédé d'adressage d'une mémoire divisée en au moins une zone, elle-même divisée en blocs et sous-blocs inclus les uns dans les autres, chaque bloc étant composé de $2^n$ mots (avec $n \geqq l$) et les sous-blocs étant composés de $2^{n1}$, $2^{n2}$,..., $2^{nm}$ mots, avec n1, n2, ..., nm $\geqq 0$ et choisis tels que $n > n1 > n2 > ... > nm$, et chaque mot étant adressable par l'intermédiaire d'un compteur d'adresse binaire, caractérisé en ce que l'adressage est réalisé de manière sélective, soit par balayage séquentiel d'un mot au mot suivant, soit au niveau du bloc.

2. Un procédé selon la revendication 1, caractérisé en ce que l'adressage est réalisé de manière sélective soit par incrémentation unitaire, soit par incrémentation de $2^n$ (avec $n \geqq 1$).

3. Un procédé selon l'une quelconque des revendications 1 et 2, caractérisé en ce qu'il comporte un retour en début de bloc.

4. Un procédé selon la revendication 3, caractérisé en ce que le retour en début de bloc est réalisé par remise à zéro des n bits de poids faible de l'adresse.

5. Un procédé selon l'une quelconque des revendications 1 à 4, caractérisé en ce que, lorsque les sous-blocs sont présents, l'adressage est en plus réalisé par incrémentation de $2^{n1}$, $2^{n2}$, ..., $2^{nm}$.

6. Un procédé selon l'une quelconque des revendications 1 à 5, caractérisé en ce que, lorsque les sous-blocs sont présents, il comporte un retour en début de sous-blocs réalisé par remise à zéro de n1, n2, ..., nm bits de poids faible de l'adresse.

7. Un compteur d'adresse binaire du type comportant m étages (AO, A1, ... A6) avec $2^m$ correspondant au nombre total de mots de la mémoire, chaque étage présentant une sortie et une entrée remise à zéro, pour la mise en oeuvre du procédé selon l'une quelconque des revendications 1 à 6, ledit compteur réalisant un comptage pas à pas, caractérisé en ce qu'il comporte de plus des moyens (10) pour réaliser une incrémentation de $2n$ (n étant inférieur ou égal à m).

8. Un compteur selon la revendication 7, caractérisée en ce qu'il comporte de plus des moyens (10') pour réaliser des incrémentations de $2n_1, 2n_2, ..., 2n_m$.

9. Un compteur selon l'une quelconque des revendications 7 et 8, caractérisé en ce que les moyens (10 ou 10') pour réaliser une incrémentation de $2n, 2n_1, 2n_2, ..., 2n_m$, sont constitués par une porte OU exclusif dont les entrées reçoivent respectivement la sortie (A4 A3) de l'étage, $n, n_1, n_2, ... n_m$ du compteur et une impulsion de saut (In ou In1') et dont la sortie est connectée en entrée de l'étage $n + 1, n_1 + 1, n_2 + 1, ..., n_m + 1$ du compteur.

10. Un compteur selon l'une quelconque des revendications 7 à 9, caractérisé en ce qu'il comporte de plus des moyens (11) de remise à zéro des n bits de poids faible de l'adresse.

11. Un compteur selon l'une quelconque des revendications 7 à 10, caractérisé en ce qu'il comporte des moyens (11') de remise à zéro des $n_1, n_2, ..., n_m$ bits de poids faible de l'adresse.

12. Un compteur selon les revendications 10 ou 11, caractérisé en ce que les moyens de remise à zéro des $n, n_1, n_2, ..., n_m$ bits de poids faible sont constitués par une porte OU (11 ou 11') recevant en entrée un signal de remise à zéro du bloc (RAZ B) ou du sous-bloc (RAZB1) et le signal de remise à zéro du compteur(RAZ), la sortie de la porte OU étant connectée sur les entrées remise à zéro des $n, n_1, n_2, ..., n_m$ étages de poids faible du compteur.

**FIG_1**

CIRCUITS-TAMPONS E/S — 6

SELECTEURS DE COLONNE — 2

DECODEUR DE COLONNE — 3

COMPTEUR D'ADRESSE — 5

DECODEUR DE LIGNE — 4

MEMOIRE — 1

$A_0$ ... $A_{10}$

$Y_1$ ... $Y_{128}$

$X_1$, $X_2$ ... $X_{128}$

BLOC DE 32 MOTS DE 8 BITS } ZONE

SOUS-BLOC DE 16 MOTS DE 8 BITS

LOGIQUE DE COMMANDE — 7

$In_1$, RAZ, $I_n$, RAZD → W

0266267

FIG_2

0266267

# FIG_3

Am  An+1  An  An-1  A₁  A₀  I  RAZ  B

# FIG_4

A₆  A₅  10  A₄  10'  A₁  A₀  I  In  In₁  RAZ B  RAZ B1  11  11'  RAZ  B

0266267

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | EP-A-0 147 268 (S.A. DE TELECOMMUNICATIONS) <br> * Page 3, ligne 15 - page 4, ligne 10; page 11, lignes 7-35; figure 4 * | 1,2 | G 06 F   12/06 <br> G 11 C    8/00 |
| A | --- | 3-6 | |
| X | PATENT ABSTRACTS OF JAPAN, vol. 8, no. 60 (P-262)[1497], 22 mars 1984; & JP-A-58 208 981 (NIPPON DENKI K.K.) 05-12-1983 | 1 | |
| A | --- <br> FR-A-1 358 354  (IBM) <br> * Page 2, colonne 2, ligne 27 - page 3, colonne 1, ligne 16; figure 3 * | 7-12 | |
| X | --- <br> FR-A-1 538 083  (IBM) <br> * Page 1, colonne 1, ligne 1 - page 2, colonne 1, ligne 57; figures 3,6 * | 1 | |
| A | --- | 2-12 | |
| A | US-A-4 612 658  (TEKTRONIX) <br> * Figure 2 * <br> ----- | 9,12 | **DOMAINES TECHNIQUES RECHERCHES (Int. Cl.4)** <br><br> G 06 F   12/06 <br> G 11 C    8/00 |

Le présent rapport a été établi pour toutes les revendications

| Lieu de la recherche | Date d'achèvement de la recherche | Examinateur |
|---|---|---|
| LA HAYE | 05-01-1988 | LECOMTE J.M. |

EPO FORM 1503 03.82 (P0402)